# FASCICULE DE BREVET EUROPEEN

(11) **EP 0 480 834 B1**
(45) Date de publication et mention de la délivrance du brevet: **14.02.1996**
(21) Numéro de dépôt: 91402705.7
(22) Date de dépôt: 10.10.1991
(51) Int. Cl.: G01R 27/02, G01R 31/00, H01B 11/18

(54) **Câble blindé formant élément de calibrage et procédé de réalisation d'un tel élément**
Kalibrierungselement bildendes abgeschirmtes Kabel und Herstellungsverfahren eines solchen Elements
Shielded cable forming calibration element and manufacturing process of such an element

(30) Priorité: 11.10.1990 FR 9012573
(43) Date de publication de la demande: 15.04.1992
(73) Titulaire: AXON'CABLE S.A., F-51210 Montmirail (FR)
(72) Inventeur: Rouchaud, Gilles, F-51210 Montmirail (FR)
(74) Mandataire: Dronne, Guy

(56) Documents cités:
- FR-A- 1 546 721
- FR-A- 2 546 333

## Description

La présente invention a pour objet un élément de calibrage pour banc de mesure de l'impédance de transfert de câbles blindés et un procédé de réalisation d'un tel élément.

De façon plus précise, l'invention concerne un élément de calibrage constitué par un élément de câble destiné à être monté dans un banc de mesure de l'impédance de transfert de câble.

Les développements récents de l'électronique ont conduit à l'accroissement important des systèmes contrôlés par de bas niveaux d'énergie, ce qui les rend de plus en plus sensibles aux perturbations électromagnétiques externes. Les spectres de fréquence de ces parasites externes s'étendent de plus en plus vers de très hautes fréquences.

Dans ces systèmes les câbles d'interconnexion constituent des points particulièrement sensibles puisqu'ils se retrouvent souvent dans des zones exposées aux ondes électromagnétiques et que, par leur géométrie, ils se comportent comme des antennes. C'est pourquoi l'utilisation de câbles blindés s'est généralisée dans ces systèmes.

Il est bien sûr important de pouvoir caractériser pour chaque câble utilisé l'efficacité de son blindage vis-à-vis des perturbations électromagnétiques. Cette caractérisation du blindage du câble se fait notamment en déterminant, à l'aide d'un banc de mesure, l'impédance de transfert de celui-ci. Pour cela, on injecte un courant perturbateur sur le blindage du câble et on mesure la tension induite à l'intérieur du câble.

Il va de soi que, pour pouvoir régler le banc de mesure, il est nécessaire de disposer d'un élément de câble blindé formant élément de calibrage.

Un tel élément de calibrage doit satisfaire à au moins deux conditions : assurer la répétitivité des mesures dans le temps et permettre une comparaison entre les valeurs expérimentales mesurées sur cet élément de calibrage et les valeurs théoriques exactes obtenues par le calcul.

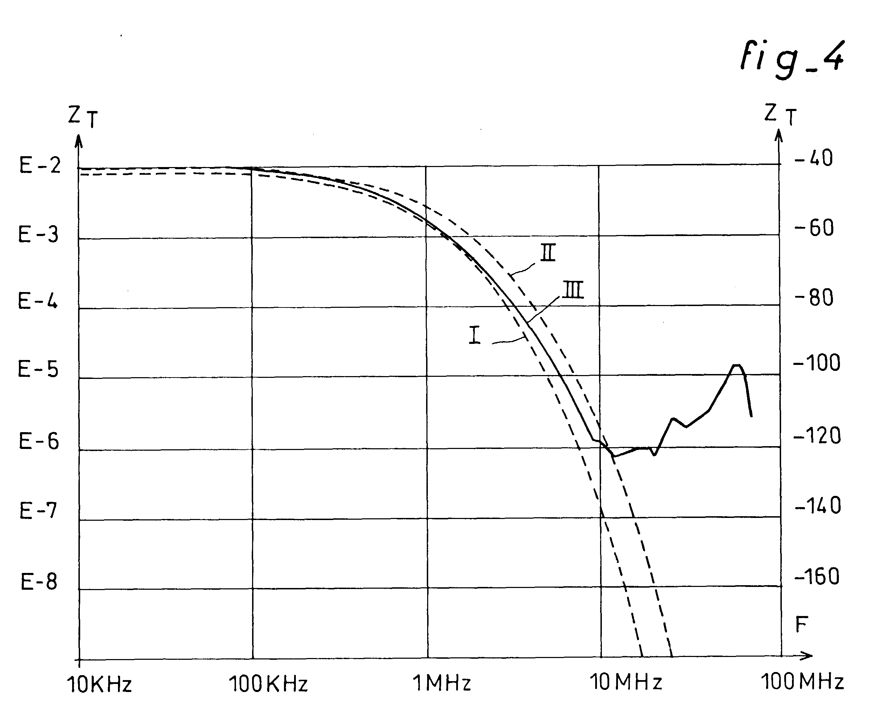

Pour répondre à ces deux impératifs on utilise comme élément de calibrage un câble semi-rigide à blindage homogène, qui est disponible dans le commerce. La théorie d'un tel câble blindé a été établie en 1934 par S.A. Schelkunnof. Cependant, lorsque la fréquence du phénomène externe perturbateur augmente, les courbes de mesure effective de l'impédance de transfert du câble formant élément de calibrage ne correspondent plus aux courbes théoriques. Sur la figure 4 annexée, on a représenté en fonction de la fréquence F l'impédance de transfert effectivement mesurée pour un câble formant élément de calibrage connu (courbe III). Les courbes I et II représentent l'impédance de transfert théorique en tenant compte des tolérances de fabrication. On voit que les courbes théoriques décroissent régulièrement alors que la courbe III correspondant aux mesures effectives est limitée vers 1 ou 2 MHz, fréquence à partir de laquelle la tension de mesure récupérée devenant trop faible disparaît dans le bruit des appareils. L'élément de calibrage décrit ci-dessus ne permet donc pas de dépasser des mesures d'impédance de transfert au-delà de la plage de un megahertz.

Or, comme on l'a déjà exposé, le spectre de fréquence des phénomènes électromagnétiques perturbateurs tend à se déplacer vers des fréquences plus élevées de l'ordre de plusieurs centaines de megahertz. Dans cette plage de fréquence, l'étalon de mesure cité ci-dessus et habituellement employé est totalement inutilisable.

Pour répondre à ce problème, on a proposé de percer des trous dans le blindage du câble formant élément de calibrage pour créer un phénomène de diffraction d'onde au travers des ouvertures ainsi réalisées. Cependant la théorie correspondant à ce type de blindage de câble, basée sur le calcul de la polarisabilité magnétique et électrique de l'ouverture pratiquée dans le câble, s'avère fastidieuse et comporte de nombreuses approximations qui limitent la validité de la comparaison des mesures expérimentales avec les valeurs théoriques de l'impédance de transfert. En outre, la réalisation pratique des ouvertures dans le blindage du câble formant élément de calibrage, qui doivent être parfaitement circulaires tout en étant réalisées sur une surface convexe, s'avère délicate et la géométrie de ces ouvertures est incertaine en raison des tolérances d'usinage.

Pour remédier à ces inconvénients, un objet de l'invention est de fournir un élément de câble blindé formant élément de calibrage, qui puisse être effectivement utilisé pour la mesure de l'impédance de transfert jusqu'à plusieurs centaines de mégahertz de champ externe perturbateur, tout en permettant de l'associer à une théorie parfaitement définie.

Pour atteindra ce but, l'élément de calibrage dans un banc de mesure de l'impédance de transfert de câbles blindés qui comprend un élément de câble blindé comportant :
une âme centrale (12);
une couche de matériau diélectrique (14) entourant ladite âme ; et
un blindage (16) formé par une couche d'un matériau conducteur homogène d'épaisseur constante e se caractérise en ce que, ladite épaisseur e est comprise entre 10 et 100 micromètres.

Selon un premier mode de mise en oeuvre, le matériau conducteur est du cuivre.

Selon un deuxième mode de mise en oeuvre, le matériau conducteur est du plomb.

L'invention concerne également un procédé de fabrication d'un câble blindé formant élément de calibrage qui se caractérise en ce que ledit blindage est obtenu par une opération de cuivrage chimique suivie d'une opération de dépôt de cuivre par électrolyse.

De toutes manières, l'invention sera mieux comprise à la lecture de la description qui suit de plusieurs modes de réalisation de l'invention donnés à titre d'exemples non limitatifs. La description se réfère aux dessins annexées sur lesquels :
- la figure 1 est une vue d'une section droite d'un élément de calibrage selon l'invention ;
- la figure 2 est une vue en coupe longitudinale de l'élément de calibrage de la figure 1;
- la figure 3 montre des courbes illustrant la comparaison entre les caractéristiques théoriques et les caractéristiques expérimentales de l'élément de calibrage des figures 1 et 2 ; et
- la figure 4 déjà décrite montre des courbes illustrant la comparaison entre les caractéristiques théoriques et les caractérisques mesurées d'un câble formant élément de calibrage de l'état de la technique.

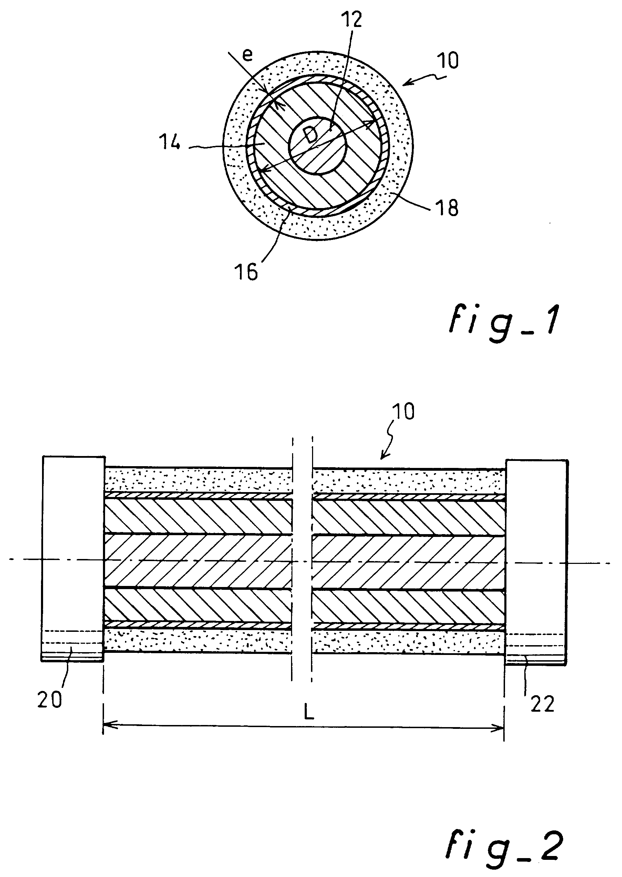

En se référant d'abord aux figures 1 et 2, on va décrire un premier mode de réalisation d'un élément de câble blindé formant élément de calibrage, qu'on appellera par simplification élément de calibrage dans la suite de la description.

L'élément de calibrage 10 comprend une âme 12 constituée de façon connue par un brin ou par une pluralité de fils conducteurs ou par un blindage coaxial selon les cas envisagés. Autour de l'âme 12, on trouve une couche 14 de matériau diélectrique. Ce matériau diélectrique est de préférence du PTFE. Le diamètre extérieur D de la couche diélectrique 14 est déterminée pour obtenir une impédance caractéristique définie entre l'âme et le blindage, par exemple 50 ohms. Selon l'invention, on réalise sur la paroi externe de la couche 14 de diélectrique une couche métallique homogène 16 d'épaisseur constante e. La couche conductrice 16 a une épaisseur e de 70 micromètres et elle est réalisée en cuivre, dans l'exemple actuellement décrit. Le procédé de réalisation de cette couche 16 sera décrit ultérieurement. Plus généralement l'épaisseur e est comprise entre 10 et 100 micromètres, l'épaisseur e dépendant de la plage de fréquence des perturbations externes considérées. L'épaisseur e du blindage est à comparer à celle des câbles-étalon de l'art antérieur qui est comprise entre 500 et 1000 micromètres.

Enfin, l'élément de calibrage comprend une couche de protection mécanique 18. Cette couche consiste, de façon connue en soi, en une gaine thermorétractable ou en une résine bicomposant.

La figure 2 montre que l'élément de calibrage comprend de plus, à chacune de ses extrémités, un élément de connexion référencé 20 et 22. Les éléments de connexion sont du type connecteurs coaxiaux BNC, N, SMA, etc... La reprise de blindage se fait à l'aide d'une ferrule soudée sur le dépôt de cuivre. Dans l'exemple décrit présentement, l'élément de calibrage 10 a une longueur L égale à 1100 mm. Cependant dans d'autres exemples de réalisation, la longueur L est comprise entre 300 et 2000 mm.

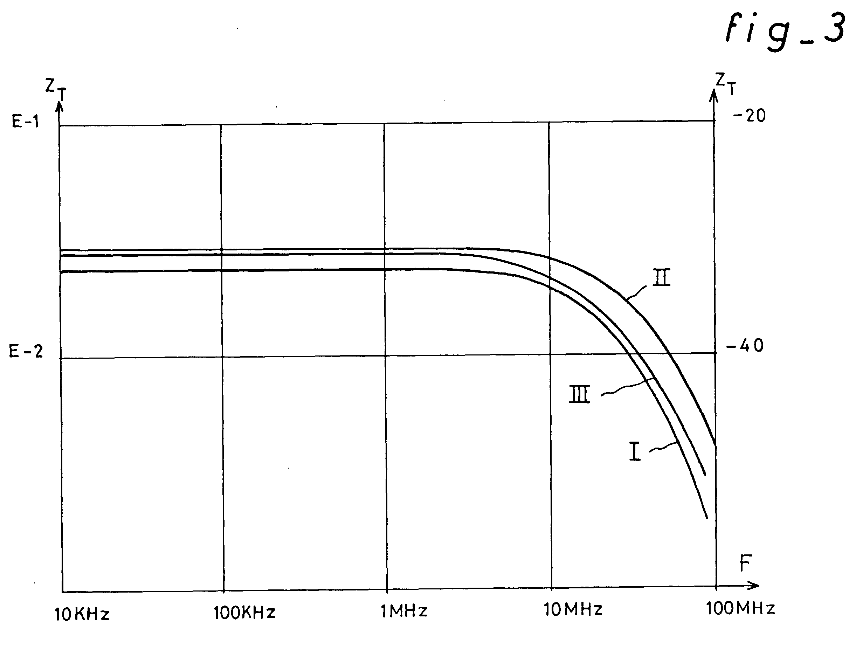

La figure 3 illustre les essais faits sur l'élément de calibrage qui vient d'être décrit. Les courbes I et II représentent les courbes théoriques calculées correspondant aux diamètres maximal et minimal du blindage compte tenu des tolérances de fabrication. La courbe III représente les valeurs de l'impédance de transfert Z_{T} de l'élément de calibrage effectivement mesurées, en fonction de la fréquence du champ électromagnétique perturbateur. Ces courbes montrent que la courbe (III) des valeurs mesurées reste effectivement comprise entre les deux courbes théoriques (I et II) jusqu'à des valeurs de fréquence (F) supérieure à la centaine de MHz. Grâce à l'utilisation d'étalons conformes à la présente invention, il est donc possible de calibrer des bancs de mesure d'impédance de transfert fonctionnant dans la gamme des centaines de MHz.

Il apparaît que ces résultats sont obtenus à l'aide de l'élément de calibrage 10 selon l'invention pour la raison suivante. Pour les fréquences élevées, au-dessus d'un MHz, le courant induit dans le blindage, par effet de peau, a tendance à se propager seulement sur la périphérie externe du blindage et ne pénètre plus à l'intérieur du câble. L'épaisseur de peau du blindage est inversement proportionnelle à la racine carrée de la fréquence. Pour les fréquences élevées mentionnées ci-dessus, la valeur de l'impédance de transfert décroit fortement et elle ˝disparait˝ devant le bruit des appareils de mesure. Grâce aux caractéristiques de l'élément de calibrage selon l'invention l'effet de peau est beaucoup moins important en termes relatifs et la mesure reste possible pour la plage de fréquences indiquée. En outre, comme l'élément de calibrage est du type à blindage homogène, il y a une très bonne correspondance entre les résultats expérimentaux et les résultats théoriques.

On va maintenant décrire un mode préféré de fabrication du élément de calibrage décrit en liaison avec les figures 1 et 2.

On réalise tout d'abord un élément de câble sans blindage c'est-à-dire ne comportant que l'âme 12 et la couche de matériau diélectrique 14.

Ensuite, on soumet la face externe de la couche 14 à une attaque chimique qui enlève le fluor et le carbone de la surface du PTFE et facilite l'accrochage ultérieur du cuivre. Le câble est alors plongé successivement dans plusieurs bains :
- bain alcalin pour enlever les traces de graisse ;
- bain de sensibilisation contenant de l'étain ;
- deuxième bain de sensibilisation contenant de l'étain et du palladium ;
- bain acide pour attaquer l'état de surface ainsi réalisé.

L'étape suivante consiste en un cuivrage chimique. Le câble est placé dans un bain contenant du cuivre et une réaction d'oxydo-réduction, où le câble est le catalyseur, dépose de 0,5 à 2 m de cuivre sur la surface du cuivre. On dépose ensuite par voie électrolytique une deuxième couche de cuivre de façon à obtenir l'épaisseur totale de cuivre souhaitée soit 70 micromètres dans l'exemple considéré. Pour cette dernière opération, on place le câble-étalon dans un bain d'acide sulfurique à 5%. L'anode est constitutée par deux plaques de cuivre de longueur et de largeur supérieures à celles du câble. La cathode est constituée par le câble lui-même. On obtient ainsi une dépôt de cuivre très homogène dont on peut ajuster l'épaisseur en choisissant la durée d'immersion et l'intensité du courant alimentant le bac à électrolyse.

Si l'on veut atteindre une plage de fréquence encore plus élevée dans le domaine des hyperfréquences, il est possible de remplacer le blindage en cuivre par un blindage en plomb dont la conductivité est inférieure à celle du cuivre.

## Revendications

1. Elément de calibrage dans un banc de mesure de l'impédance de transfert de câbles blindés, qui comprend un élément de câble blindé comportant :
une âme centrale (12);
une couche de matériau diélectrique (14) entourant ladite âme ; et
un blindage (16) formé par une couche d'un matériau conducteur homogène d'épaisseur constante e, caractérisé en ce que ladite épaisseur e est comprise entre 10 et 100 micromètres.

2. Elément de calibrage selon la revendication 1, caractérisé en ce que ledit matériau conducteur est du cuivre.

3. Elément de calibrage selon la revendication 2, caractérisé en ce que ladite épaisseur e est de l'ordre de 70 micromètres.

4. Elément de calibrage selon la revendication 1, caractérisé en ce que ledit matériau conducteur est du plomb.

5. Elément de calibrage selon l'une quelconque des revendications 1 à 4, caractérisé en ce qu'il comprend en outre une gaine isolante (18) entourant ladite couche de matériau conducteur.

6. Procédé de réalisation d'un élément de câble blindé formant élément de calibrage pour banc de mesure de l'impédance de transfert de câbles blindés, qui comprend les étapes suivantes :
- on fournit un élément de câble comprenant une âme (12) entourée d'une couche de matériau diélectrique (14);
- on dépose par voie chimique une première épaisseur d'un matériau conducteur sur ledit matériau diélectrique ; et
- on dépose par électrolyse une deuxième épaisseur du matériau conducteur de telle manière que l'épaisseur totale de matériau conducteur soit homogène d'épaisseur constante e, e étant compris entre 10 et 100 micromètres.

7. Procédé selon la revendication 6, caractérisé en ce qu'il comprend, avant l'étape de dépôt chimique, une étape d'attaque chimique de la surface externe du matériau diélectrique (14).

8. Procédé selon l'une quelconque des revendications 6 et 7, caractérisé en ce que ledit matériau conducteur est du cuivre.

9. Procédé selon l'une quelconque des revendications 6 à 8, caractérisé en ce que le dépôt par voie chimique a une épaisseur de 0,5 à 1 micromètre.

## Patentansprüche

1. Kalibrierungselement in einer Einrichtung zur Messung der Übertragungsimpedanz von abgeschirmten Kabeln, das ein abgeschirmtes Kabelelement umfaßt mit:
einem zentralen Kern (12);
einer Schicht dielektrischen Materials (14) die den Kern umgibt; und
einer Abschirmung (16), die von einer homogenen Schicht leitenden Materials einer konstanten Dicke e gebildet ist, dadurch gekennzeichnet, daß die Dicke e zwischen 10 und 100 Mikrometer beträgt.

2. Kalibrierungselement nach Anspruch 1, dadurch gekennzeichnet, daß das leitende Material aus Kupfer besteht.

3. Kalibrierungselement nach Anspruch 2, dadurch gekennzeichnet, daß die Dicke e in der Größenordnung von 70 Mikrometer ist.

4. Kalibrierungselement nach Anspruch 1, dadurch gekennzeichnet, daß das leitende Material aus Blei besteht.

5. Kalibrierungselement nach einem der Ansprüche 1 bis 4, dadurch gekennzeichnet, daß es des weiteren eine Isolierschicht (18), die die leitende Materialschicht umgibt, aufweist.

6. Herstellungsverfahren für ein Element eines abgeschirmten Kabels, das ein Kalibrierungselement für eine Einrichtung zum Messen der Übertragungsimpedanz abgeschirmter Kabel bildet, das folgende Schritte umfaßt:
- das Bereitstellen eines Kabelelements mit einem Kern (12), der von einer Schicht dielektrischen Materials (14) umgeben ist;
- das chemische Niederschlagen einer ersten Dicke eines leitenden Materials auf dem dielektrischen Material; und
- das galvanische Niederschlagen einer zweiten Dicke des leitenden Materials derart, daß die Gesamtdicke des leitenden Materials homogen mit einer konstanten Dicke e ist, die zwischen 10 und 100 Mikrometer beträgt.

7. Verfahren nach Anspruch 6, dadurch gekennzeichnet, daß vor dem Schritt des chemischen Niederschlagens ein Schritt der chemischen Einwirkung auf die äußere Oberfläche des dielektrischen Materials (14) erfolgt.

8. Verfahren nach Anspruch 6 oder 7, dadurch gekennzeichnet, daß das leitende Material aus Kupfer besteht.

9. Verfahren nach einem der Ansprüche 6 bis 8, dadurch gekennzeichnet, daß der chemische Niederschlag eine Dicke von 0,5 bis 1 Mikrometer hat.

## Claims

1. Calibrating element in a bench for measuring the transfer impedance of armoured cables which includes an armoured cable element comprising:
a central core (12);
a layer of dielectric material (14) surrounding said core; and
armour (16) formed by a layer of a homogeneous conductive material of constant thickness e, characterised in that said thickness e is between 10 and 100 micrometres.

2. Calibrating element according to claim 1, characterised in that said conductive material is copper.

3. Calibrating element according to claim 2, characterised in that said thickness e is of the order of 70 micrometres.

4. Calibrating element according to claim 1, characterised in that said conductive material is lead.

5. Calibrating element according to any of claims 1 to 4, characterised in that it further includes an insulating sheath (18) surrounding said layer of conductive material.

6. Method for manufacturing an armoured cable element forming a calibrating element for a bench for measuring the transfer impedance of armoured cables which includes the following steps:
- a cable element including a core (12) surrounded by a layer of dielectric material (14) is supplied;
- a first thickness of a conductive material is deposited on said dielectric material chemically; and
- a second thickness of the conductive material is deposited by electrolysis in such a way that the total thickness of conductive material is homogeneous of constant thickness e, e being between 10 and 100 micrometres.

7. Method according to claim 6, characterised in that it includes, before the step of chemical deposition, a step of chemically etching the outer surface of the dielectric material (14).

8. Method according to either of claims 6 and 7, characterised in that said conductive material is copper.

9. Method according to any of claims 6 to 8, characterised in that the chemically deposited material has a thickness of 0.5 to 1 micrometre.
